Europäisches Patentamt

European Patent Office

Office européen des brevets

(19)

(11) Numéro de publication: **0 200 600**
**B1**

## (12) FASCICULE DE BREVET EUROPEEN

(45) Date de publication du fascicule du brevet:
**03.01.90**

(51) Int. Cl.⁴: **H03K 17/04**

(21) Numéro de dépôt: **86400668.9**

(22) Date de dépôt: **27.03.86**

(54) **Circuit de commande de base de transistor fonctionnant à fréquence élevée.**

(30) Priorité: **02.04.85 FR 8505010**

(43) Date de publication de la demande:
**10.12.86 Bulletin 86/45**

(45) Mention de la délivrance du brevet:
**03.01.90 Bulletin 90/1**

(84) Etats contractants désignés:
**DE FR GB IT NL**

(56) Documents cités:
**DE-A- 3 040 365**
**US-A- 3 569 742**
**US-A- 4 234 805**

**IBM TECHNICAL DISCLOSURE BULLETIN,**
**vol. 24, no. 11A, avril 1982, pages 4399-5500, New York,**
**US; R.P. RIZZO et al.: "Self-excited turn-off circuit"**

(73) Titulaire: **THOMSON-CSF, 51, Esplanade du Général de Gaulle, F-92800 Puteaux(FR)**

(72) Inventeur: **Rischmuller, Klaus, THOMSON-CSF SCPI 19, avenue de Messine, F-75008 Paris(FR)**

(74) Mandataire: **de Beaumont, Michel et al, 1bis, rue Champollion, F-38000 Grenoble(FR)**

## Description

La présente invention concerne la commande en commutation des transistors de puissance à des fréquences élevées, par exemple dans la gamme de 10 à 100 kilohertz.

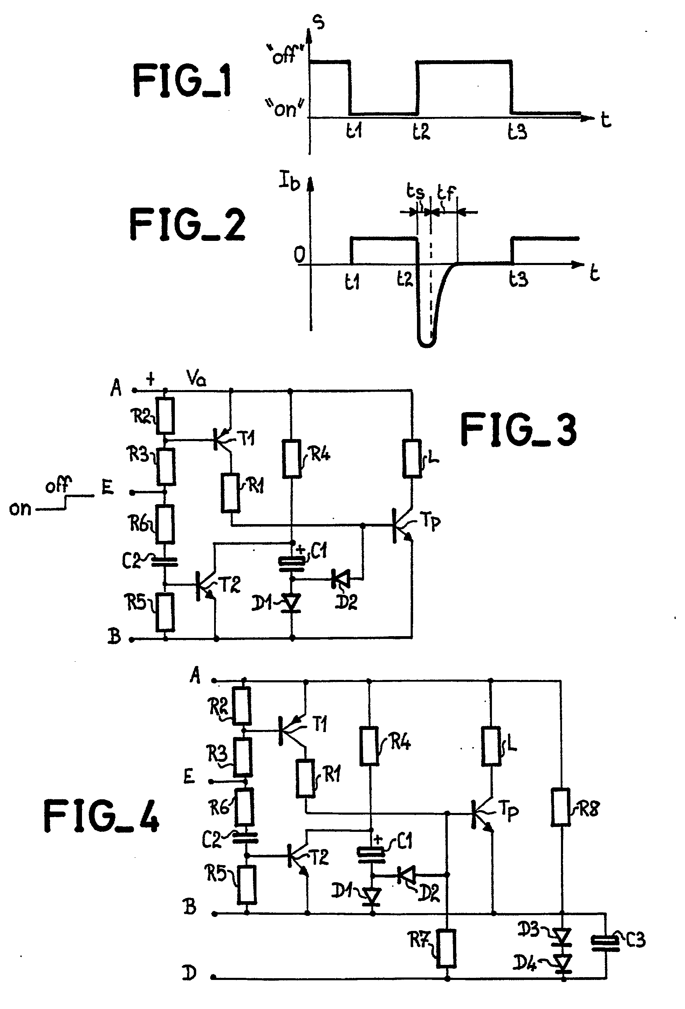

Etant donné un signal d'ordre de commutation S (figure 1) susceptible de passer d'un premier état ou état "off", dans lequel le transistor de puissance est bloqué, à un deuxième état ou état "on" dans lequel le transistor de puissance est conducteur, il est connu que, si l'on souhaite une commutation rapide d'un état à l'autre, le courant de base Ib du transistor ait l'allure représentée à la figure 2. Comme le montre la figure 2, le courant de base Ib doit être d'une première polarité lorsque le transistor doit être conducteur. On appellera ci-après par convention courant de base positif le courant qui rend le transistor conducteur; cette convention correspond à un courant entrant dans la base pour un transistor de puissance NPN. A l'instant où le signal S passe de l'état "on" à l'état "off", il ne suffit pas de mettre à zéro le courant de base Ib mais il faut initialement extraire de la base un courant de polarité inverse (qu'on appellera courant de base négatif par convention). Ce courant négatif est absolument nécessaire si on veut assurer une commutation rapide du transistor de l'état conducteur vers l'état bloqué. En effet, seul ce courant de base négatif permet d'éliminer assez rapidement les charges électriques qui se sont accumulées dans la base du transistor pendant la période de conduction. Le courant de base négatif est sensiblement constant pendant une durée ts suivant l'ordre de blocage (temps de déstockage) puis il revient à zéro pendant une durée tf (temps de descente).

A priori, pour donner au courant de base cette allure générale, il faut disposer de deux sources d'alimentation de polarités opposées. Ceci constitue un inconvénient évident, et on a donc cherché à réaliser des circuits capables de fournir le courant de base négatif sans source d'alimentation négative. Pour cela, on utilise en général un condensateur ou une inductance qui stocke de l'énergie pendant la période de conduction du transistor et la restitue sous forme de courant de base négatif au moment où on déclenche l'ordre de blocage du transistor.

Toutefois la plupart des circuits réalisés jusqu'à maintenant dont le circuit connu du document DE-A 3 040 365 est un exemple souffrent d'un inconvénient important: pour que le circuit fonctionne convenablement, il faut que le condensateur ou l'inductance ait le temps de stocker suffisamment d'énergie pendant la durée de conduction. Cela impose que la durée de conduction ait une valeur minimale qui ne soit pas trop faible.

Si la période de commutation est faible (travail à haute fréquence), cette valeur minimale devient une fraction très importante de la période de commutation et on ne peut plus faire fonctionner le circuit avec un faible rapport cyclique de conduction, c'est-à-dire avec un faible rapport entre la durée de conduction et la période de commutation.

La présente invention propose un nouveau circuit de commande de conduction et blocage d'un transistor de puissance qui, tout étant très simple et tout en n'utilisant qu'un faible nombre de composants, élimine cet inconvénient.

Le circuit selon l'invention telle que revendiquée comprend comme dans la technique connue une entrée de commande reliée à un circuit de mise en conduction et à un circuit de blocage, le circuit de mise en conduction fournissant au transistor de puissance un courant de base positif ou nul selon l'état de l'entrée de commande, et le circuit de blocage fournissant d'abord un courant de base initial négatif lors de la réception d'un ordre de blocage sur l'entrée de commande puis un courant de base nul.

De plus, selon l'invention telle que revendiquée, le circuit de blocage comprend les éléments suivants :
- un condensateur pour stocker de l'énergie nécessaire à la production d'un courant négatif de base ;
- un moyen pour charger le condensateur pendant la période de conduction et pendant la période de blocage du transistor de puissance ;
- un interrupteur commandé pour établir un circuit de décharge du condensateur dans la base du transistor de puissance, le courant circulant dans ce circuit de décharge lors de la fermeture de l'interrupteur correspondant à un courant de base négatif ;
- un circuit de commande de fermeture temporaire de l'interrupteur, ce circuit commandant la fermeture de l'interrupteur dès la réception d'un ordre de blocage sur l'entrée de commande et pendant une courte durée prédéterminée qui est de l'ordre de grandeur du temps de déstockage du transistor de puissance.

Dans un mode de réalisation préférentiel de l'invention, le condensateur a une première armature reliée d'une part à un moyen de charge et d'autre part au circuit émetteur-collecteur d'un transistor-interrupteur, et une deuxième armature reliée à une première diode orientée dans un sens permettant au condensateur de se charger par le moyen de charge pendant tout le temps que le transistor interrupteur est bloqué. Une deuxième diode est reliée entre la base du transistor de puissance et la deuxième armature du condensateur et est orientée dans un sens permettant le passage d'un courant de base négatif à travers un circuit de décharge constitué par la base du transistor de puissance, la deuxième diode, le condensateur, et le transistor-interrupteur (lorsque celui-ci est rendu conducteur); enfin, le circuit de commande de fermeture temporaire de l'interrupteur comprend un ensemble en série d'au moins une résistance et une capacité, cet ensemble constituant un réseau RC série relié à l'entrée de commande de manière que la capacité puisse recevoir un courant de charge lorsque l'entrée reçoit un signal de commande de blocage du transistor de puissance; l'ensemble RC série est par ailleurs connecté à une borne de commande du transistor-interrupteur, pour d'une part transmettre instantanément un signal de mise en conduction du transistor-interrupteur, lors de la réception d'un signal de commande de blocage du transistor de puissance, d'autre part pour commencer au même moment l'application d'un courant de charge à la capacité du réseau RC, et enfin pour interrompre la mise en conduction du transistor interrupteur au bout d'un temps déterminé par la constante de temps de charge de la capacité du réseau RC, ce temps étant de l'ordre du temps de déstockage des charges du transistor de puissance.

D'autres caractéristiques et avantages de l'invention apparaîtront à la lecture de la description détaillée qui suit et qui est faite en référence aux dessins annexés dans lesquels :

- les figures 1 et 2 déjà décrites représentent des diagrammes temporels du signal de commande appliqué à l'entrée d'un circuit de commande de transistor de puissance et le courant de base qui doit en résulter ;
- la figure 3 représente un mode de réalisation préférentiel de l'invention ;
- la figure 4 représente une variante de· réalisation.

Le circuit selon l'invention est représenté dans sa réalisation préférentielle à la figure 3.

Le transistor de puissance est désigné par la référence Tp. L'entrée de commande du circuit est E. L'ensemble du circuit est alimenté entre deux bornes d'alimentation A et B dont l'une (B) peut être constituée par une masse électrique et l'autre (A) est portée à un potentiel d'alimentation positif Va.

Le transistor Tp autorise ou interdit le passage d'un courant dans une charge L reliée entre son collecteur et un potentiel d'alimentation positif qui peut être le potentiel Va. L'émetteur du transistor Tp est de préférence relié à la masse B.

Pour l'application d'un courant de base positif, un circuit de mise en conduction est prévu; pour l'application d'un courant de base négatif, un circuit de blocage est prévu ; ces deux circuits sont reliés à l'entrée E qui les commande.

Le circuit de mise en conduction comprend ici les éléments suivants : un transistor T1, PNP, ayant son émetteur relié à la borne A et son collecteur relié par une résistance R1 à la base du transistor Tp. La base du transistor T1 est reliée au point milieu d'un pont diviseur R2, R3 qui est connecté entre les bornes A et E. Selon que le niveau de tension sur l'entrée E est bas (commande de mise en conduction du transistor Tp) ou haut (commande de blocage), le transistor T1 applique un courant ou interrompt le courant dans la base du transistor Tp.

Le circuit de mise en conduction est donc très simple et pourrait d'ailleurs être remplacé par d'autres variantes de circuit telles qu'une simple source de courant connectée entre la borne A et la base de Tp, cette source étant commandée par la borne E.

Le circuit de commande de blocage comprend les autres éléments de la figure 3, c'est-à-dire :
- un condensateur ·C1 qui sert à stocker l'énergie nécessaire à la production d'un courant de base négatif pour assurer le déstockage des charges au début du blocage du transistor Tp ;
- une résistance R4 et une diode D1 qui servent à charger le condensateur C1,
- un interrupteur constitué ici par un transistor T2, NPN ; cet interrupteur établit, lorsqu'il se ferme, un circuit de décharge du condensateur C1,
- un circuit de commande de l'interrupteur, comprenant deux résistances R5, R6 et une capacité C2 ;
- et enfin une diode D2 reliée entre la base et le condensateur C1 et ayant plusieurs fonctions indiquées plus loin.

Plus précisément, les éléments du circuit sont connectés de la manière suivant : les diodes D1 et D2 sont en série (et ont la même polarité) entre la base du transistor Tp et la borne B ; le point de jonction des diodes est relié à une armature du condensateur C1 ; l'autre armature de ce condensateur est reliée par la résistance R4 à la borne A et est reliée par ailleurs au collecteur du transistor-interrupteur T2 ; l'émetteur du transistor T2 est relié à la borne B ; la base du transistor T2 est reliée à une borne de la capacité C2 et à une borne de la résistance R5; l'autre borne de la résistance R5 est reliée à la masse B; l'autre borne de la capacité C2 est reliée par la résistance R6 à l'entrée de commande E.

Le circuit fonctionne de la manière suivante : pour la mise en conduction, l'entrée E est portée à un potentiel bas, ce qui d'une part rend conducteur le transistor T1 et applique un courant de base positif au transistor de puissance Tp qui se met à conduire, et d'autre part décharge la capacité C2 à travers les résistances R5 et R6 avec une constante de temps (R5 + R6) C qui est brève (de l'ordre du temps de déstockage du transistor Tp). On peut réduire à une valeur encore plus faible la durée de décharge de la capacité C2 en prévoyant en outre une diode ou deux en parallèle sur les résistances R5 et R6, la diode étant montée de manière à permettre l'évacuation de la charge de la capacité C2 lorsque l'entrée E est mise au potentiel bas. Pendant ce temps le condensateur C1 se charge ou plus exactement continue à se charger si sa charge a déjà commencé avant le signal de mise en conduction, ce qui sera le plus souvent le cas, sauf peut être pour des rapports cycliques de conduction très proches de l'unité. La charge de C1 se fait à travers R4 et D1.

Pour le blocage du transistor Tp, l'entrée E est portée à un potentiel haut. Ceci a pour effet de bloquer immédiatement le transistor T1 et donc d'interrompre le courant de base positif. D'autre part, le niveau de potentiel haut sert à polariser immédiatement le transistor T2 dans un état conducteur, le rapport des résistances R5 et R6 étant choisi tel que la tension appliquée à la base du transistor T2 soit une fraction suffisante du potentiel présent entre les bornes A et E. On rappelle à ce propos que le condensateur C2 est initialement déchargé. Dans ces conditions, le transistor T2 devient un quasi court-circuit et établit un circuit de décharge du condensateur C1. Comme le transistor T1 est bloqué et comme la diode D1 est orientée dans un sens permettant la charge mais non la décharge du condensateur C1, le courant de décharge ne peut provenir que de la diode D2 et, sous forme de courant de base négatif, de la base du transistor Tp.

Pendant que le condensateur C1 se décharge ainsi et permet l'écoulement des charges stockées dans la base du transistor, la capacité C2 se charge à travers la résistance R6. Au bout d'un certain temps, dépendant de la constante de temps de charge de la capacité et de la valeur du potentiel haut appliqué à l'entrée E, la base du transistor T2 ne reçoit plus un courant suffisant pour maintenir le transistor T2 conducteur. Celui-ci se bloque donc (progressivement) et le courant négatif de base, après une diminution progressive, s'interrompt totalement.

On choisit la constante de temps de charge de la capacité C2 (à travers la résistance R6 et l'ensemble en parallèle de la résistance R5 et de la jonction base-émetteur du transistor T2), pour que l'interruption de la conduction du transistor T2 et donc l'interruption du courant négatif de base ait lieu au bout d'un temps qui est de l'ordre de grandeur du temps tsou ts + tf (figure 2) ; l'idéal est de se rapprocher le plus possible par valeur supérieure, de cette durée ts + tf, dont l'ordre de grandeur est de quelques microsecondes.

Par sécurité on choisira une constante de temps sensiblement supérieure à ts + tf pour un transistor donné supposé commuter dans des conditions normales ; une valeur 2(ts + tf) parait raisonnable.

Dès que le transistor T2 est bloqué, c'est-à-dire au bout d'un temps très court devant la période de commutation, le condensateur C1 commence à se recharger à travers la résistance R4 et la diode D1.

Il est important de constater que le condensateur C1 se recharge alors que le transistor de puissance Tp est bloqué; la charge de C1 se poursuit d'ailleurs pendant toute la suite de la durée de blocage et également pendant toute la durée de conduction qui suit.

On peut préciser ici le triple rôle de la diode D2 dans ce circuit.

Pendant la majeure partie de la période de blocage (c'est-à-dire après la phase transitoire où le courant de base est négatif), la diode D2 empêche qu'un courant de base positif ne soit appliqué à la base du transistor Tp par suite de la charge du condensateur C1 (si une connexion directe existait entre le condensateur C1 et la base, le courant de charge de C1 pourrait passer à travers la base du transistor Tp et le rendre conducteur alors qu'on est en phase de blocage).

Pendant la phase où un courant de base négatif doit être produit, la diode D2 permet par son orientation le passage de ce courant négatif.

Enfin, pendant la phase de conduction, la diode D2 permet, avec l'aide de la diode D1, qu'une tension de polarisation suffisante (deux chutes de tension de diodes en direct) existe entre base et émetteur du transistor Tp.

La figure 4 représente une variante de réalisation dans laquelle on désire que la base du transistor de puissance soit polarisée négativement par rapport à l'émetteur pendant toute la durée de blocage; c'est le cas en particulier lorsqu'on a plusieurs transistors montés en pont.

Par rapport au schéma de la figure 3, la différence principale est que la borne B ne constitue plus une borne d'alimentation mais seulement un noeud du circuit. La borne d'alimentation est une borne D et une résistance, deux diodes et un condensateur (dans l'exemple représenté) sont rajoutés: plus précisément, une résistance R7 relie la base à la deuxième borne d'alimentation D ; une résistance R8 relie la borne A au noeud B ; deux diodes en série D3 et D4 relient le noeud B (côté anode) à la borne D (côté cathode) et un condensateur C3 est placé en parallèle sur les diodes D3 et D4 entre les bornes B et D. Le condensateur C3 chargé par la résistance R8 maintient entre les bornes B et D une différence de potentiel constante, limitée par les diodes à une valeur d'environ 1,3 volts. Par la résistance R7, cette différence de potentiel est appliquée à la jonction base émetteur du transistor Tp, le potentiel de base étant alors négatif par rapport au potentiel d'émetteur.

D'autres variantes de schéma sont possibles sans sortir du cadre de l'invention. En particulier le circuit de commande de la base du transistor T2 peut être réalisé différemment pourvu qu'il assure la fonction définie ci-dessus, à savoir la polarisation immédiate du transistor T2 dans un état conducteur dès la transition du signal appliqué à l'entrée E, puis la coupure du transistor T2 au bout d'un temps très court mais suffisant pour assurer le déstockage des charges du transistor de puissance Tp.

Il faut noter encore que ce n'est qu'à titre d'exemple qu'on a choisi un niveau de potentiel bas pour le signal "on" de mise en conduction et un niveau haut pour le signal "off" de blocage.

## Revendications

1. Circuit de commande de commutation d'un transistor de puissance (Tp), comprenant une entrée de commande (E) reliée à un circuit de mise en conduction et à un circuit de blocage, le circuit de mise en conduction (R1, R2, R3, T1) fournissant au transistor de puissance (Tp) un courant de base positif ou nul selon le niveau de l'entrée (E), et le circuit de blocage fournissant un courant de base initialement négatif lors de la réception d'un ordre de blocage sur l'entrée de commande, puis un courant de base nul, le circuit de blocage comprenant:
   – un condensateur (C1) pour stocker de l'énergie nécessaire à la production d'un courant négatif de base,
   – un moyen (R4, D1) de charge du condensateur pendant la conduction du transistor de puissance (Tp),
   – un interrupteur commandé (T2) pour établir un circuit de décharge du condensateur (C1) dans la base du transistor de puissance en produisant un courant de base de sens négatif lors de la fermeture de l'interrupteur, caractérisé en ce que ledit moyen de charge du condensateur agit également pendant le blocage du transistor de puissance (Tp) en dehors d'une courte durée déterminée et en ce que ce circuit de blocage comprend en outre:
   – un circuit (R6, R5, C2) de commande de fermeture temporaire de l'interrupteur (T2), ce circuit commandant la fermeture de l'interrupteur dès la réception d'un ordre de blocage sur l'entrée de commande et pendant ladite courte durée prédéterminée qui est de l'ordre de grandeur du temps de déstockage du transistor de puissance.

2. Circuit de commande de commutation d'un transistor de puissance selon la revendication 1, caractérisé en ce que le condensateur (C1) a une armature reliée à une première diode (D1) orientée dans un sens permettant au condensateur de se charger lorsque l'interrupteur est ouvert.

3. Circuit de commande de commutation d'un transistor de puissance selon la revendication 2, caractérisé en ce qu'une deuxième diode (D2) est reliée entre la même armature et la base du transistor de puissance, et orientée dans un sens permettant le passage d'un courant de base négatif dans le circuit de décharge constitué par la base du transistor de puissance, la deuxième diode, le condensateur et l'interrupteur.

4. Circuit de commande de commutation d'un transistor de puissance selon l'une quelconque des revendications 1 à 3, caractérisé en ce que le circuit de commande de l'interrupteur comporte un ensemble en série d'au moins une résistance (R5) et une capacité (C2), relié entre l'entrée de commande et une borne d'alimentation et connecté par ailleurs à une borne de commande de l'interrupteur (T2), de manière que l'interrupteur soit instantanément fermé lors de la réception d'un ordre de blocage sur l'entrée de commande (E) et qu'il reste conducteur jusqu'à ce que la charge de la capacité, commencée à la réception de l'ordre de blocage, ait atteint une valeur correspondant à une ouverture de l'interrupteur, la constante de temps de charge de la capacité étant choisie de manière que la durée de fermeture de l'interrupteur soit de l'ordre de la durée de déstockage du transistor de puissance.

5. Circuit de commande de commutation d'un transistor de puissance selon l'une quelconque des revendications 1 à 4, caractérisé en ce que l'interrupteur est un transistor dont le circuit émetteur-collecteur est relié en parallèle avec l'ensemble en série du condensateur (C1) et d'une première diode (D1).

**Claims**

1. A switching control circuit for a power transistor (Tp), comprising a control input (E) connected to an enabling circuit and to a disabling circuit, the enabling circuit (R1, R2, R3, T1) delivering to the power transistor (Tp) a positive or zero base current depending on the level of the input (E), and the disabling circuit delivering an initially negative base current on reception of a disabling order at the control input, then a zero base current, said enabling circuit comprising:
 – a capacitor (C1) for storing the energy required for producing a negative base current,
 – means (R4, D1) for charging the capacitor during the enabled time of the power transistor,
 – a controlled switch for establishing a circuit for discharging the capacitor (C1) in the base of the power transistor by producing a base current of negative direction on closure of the switch,
characterized in that said capacitor charging means also operates during the disable time of the power transistor (Tp) except during a short predetermined time and in that said disabling circuit further comprises:

 – a circuit (R6, R5, C2) for controlling temporary closure of the switch as soon as a disabling order is received at the control input and during said short predetermined time which is of the order of size of the time required for destoring the power transistor.

2. The switching control circuit for a power transistor as claimed in claim 1, characterized in that said capacitor (C1) has a plate connected to a first diode (D1) oriented in one direction for allowing the capacitor to be charged when the switch is open.

3. The switching control circuit for a power transistor as claimed in claim 2, characterized in that a second diode (D2) is connected between the same plate and the base of the power transistor and is oriented in a direction allowing a negative base current to pass through the discharge circuit formed by the base of the power transistor, the second diode, the capacitor and the switch.

4. The switch control circuit for a power transistor as claimed in any one of claims 1 to 3, characterized in that the circuit for controlling the switch comprises a series assembly of at least one resistor (R5) and one capacitor (R2), connected between the control input and a supply terminal and further connected to a control terminal of the switch (T2), so that said switch is closed instantaneously on reception of a disabling order at the control input (E) and remains enabled until the charge on the capacitor, begun on reception of the disabling order, has reached a value corresponding to an opening of the switch, the charging time constant of the capacitor being chosen so that the closing time of the switch is of the order of the time required for destoring the power transistor.

5. The switch control circuit for a power transistor as claimed in any one of claims 1 to 4, characterized in that said switch is a transistor whose emitter-collector circuit is connected in parallel across the series assembly of the capacitor (C1) and a first diode (D1).

**Patentansprüche**

1. Steuerschaltung zum Umschalten eines Leistungstransistors (Tp), mit einem Steuereingang (E), der an eine Schaltungsanordnung zum Schalten in den Durchlaßzustand und an eine Sperrschaltung angeschlossen ist, wobei die Schaltungsanordnung (R1, R2, R3, T1) zum Schalten in den Durchlaßzustand je nach Schaltzustand des Eingangs (E) dem Leistungstransistor (Tp) einen positiven Basisstrom oder einen Nullbasisstrom liefert, und die Sperrschaltung bei Empfang eines Sperrbefehls am Steuereingang einen anfänglich negativen Basisstrom, sodann einen Nullbasisstrom liefert, bei die Sperrschaltung
 – einen Kondensator (C1) zum Speichern von zum Erzeugen des negativen Basisstroms notwendiger Energie,
 – eine Einrichtung (R4, D1) zum Laden des Kondensators während des Durchlaßzustandes des Leistungstransistors (Tp),
 – einen gesteuerten Schalter (T2) zum Errichten eines Entladekreises für den Kondensator (C1) in der Basis des Leistungstransistors durch Erzeugen eines Basisstroms negativer Richtung beim Schließen des Schalters umfaßt, dadurch gekennzeichnet, daß die Einrichtung zum Laden des Kondensators außer während einer vorbestimmten kurzen Zeitspanne auch während der Sperrung des Leistungstransistors (Tp) wirksam ist, und daß diese Sperrschaltung außerdem
– eine Schaltungsanordnung (R6, R5, C2) zum Steuern des vorübergehenden Schließens vom Schalter (T2) umfaßt, die den Schalter bei Empfang eines Sperrbefehls am Steuereingang und während der genannten vorbestimmten kurzen Zeitspanne, die von der Größenordnung der Entladezeit des Leistungstransistors ist, schließt.

2. Steuerschaltung zum Umschalten eines Leistungstransistors nach Anspruch 1, dadurch gekennzeichnet, daß der Kondensator (C1) eine Elektrode aufweist, die mit einer ersten Diode (D1) verbunden ist, welche so geschaltet ist, daß sie das Laden des Kondensators bei geöffnetem Schalter ermöglicht.

3. Steuerschaltung zum Umschalten eines Leistungstransistors nach Anspruch 2, dadurch gekennzeichnet, daß zwischen dieselbe Elektrode und die Basis des Leistungstransistors eine zweite Diode (D2) so zwischengeschaltet ist, daß sie in dem von der Basis des Leistungstransistors, der zweiten Diode, dem Kondensator und dem Schalter gebildeten Entladekreis das Fließen eines negativen Basisstroms ermöglicht.

4. Steuerschaltung zum Umschalten eines Leistungstransistors nach einem der Ansprüche 1 bis 3, dadurch gekennzeichnet, daß die Steuerschaltung für den Schalter eine Serienschaltung aus wenigstens einem Widerstand (R5) und einem Kondensator (C2) umfaßt, welche zwischen den Steuereingang und eine Speiseanschlußklemme zwischengeschaltet und außerdem an eine Steuerklemme des Schalters (T2) angeschlossen ist, derart, daß der Schalter bei Empfang eines Sperrbefehls am Steuereingang (E) augenblicklich geschlossen wird und im Durchlaßzustand bleibt, bis die bei Empfang des Sperrbefehls begonnene Aufladung des Kondensators einen einer Öffnung des Schalters entsprechenden Wert erreicht hat, wobei die Zeitkonstante für das Laden des Kondensators so gewählt ist, daß die Schließzeit des Schalters etwa gleich der Entladezeit des Leistungstransistors ist.

5. Steuerschaltung zum Umschalten eines Leistungstransistors nach einem der Ansprüche 1 bis 4, dadurch gekennzeichnet, daß der Schalter ein Transistor ist, dessen Emitter-Kollektor-Kreis mit der Serienschaltung des Kondensators (C1) und der ersten Diode (D1) parallelgeschaltet ist.

EP 0 200 600 B1

FIG_1

FIG_2

FIG_3

FIG_4